# EUROPEAN PATENT APPLICATION

(11) **EP 4 474 662 A1**
(43) Date of publication of application: **11.12.2024**
(21) Application number: 24761480.3
(22) Date of filing: 01.03.2024
(51) Int. Cl.: F16C 11/04

(54) **HINGE MECHANISM AND ELECTRONIC DEVICE**

(30) Priority: 28.04.2023 CN 202310482978
(71) Applicant: HUAWEI TECHNOLOGIES CO., LTD., Shenzhen, Guangdong 518129 (CN)
(72) Inventor: LIAO, Changliang, Shenzhen, Guangdong 518129 (CN); ZHONG, Ding, Shenzhen, Guangdong 518129 (CN); JIAO, Tao, Shenzhen, Guangdong 518129 (CN)
(74) Representative: Pfenning, Meinig & Partner mbB
(86) International application number: PCT/CN2024/079731
(87) International publication number: WO 2024/222200

(57) **Abstract**

This application discloses a hinge mechanism and an electronic device, to improve reliability of movement of the hinge mechanism and reduce a size of the hinge mechanism. The hinge mechanism includes a base, a first rotating component, a second rotating component, and a synchronization component. The first rotating component includes a first swing arm, and the first swing arm is rotatably connected to the base. The second rotating component includes a second swing arm, and the second swing arm is rotatably connected to the base. The synchronization component includes a first driving arm, a second driving arm, a first sliding block, and a second sliding block. One end of the first driving arm is rotatably connected to an end that is of the first swing arm and that is close to the base, another end of the first driving arm is rotatably connected to the first sliding block, and the first sliding block is slidably disposed on the base in a first direction. One end of the second driving arm is rotatably connected to an end that is of the second swing arm and that is close to the base, another end of the second driving arm is rotatably connected to the second sliding block, and the second sliding block is slidably disposed on the base in the first direction. The first sliding block and the second sliding block are spaced in an axial direction of the hinge mechanism, and the first sliding block is in transmission connection to the second sliding block.

## Description

### CROSS-REFERENCE TO RELATED APPLICATIONS

This application claims priority to Chinese Patent Application No. 202310482978.5, filed with the China National Intellectual Property Administration on April 28, 2023 and entitled "HINGE MECHANISM AND ELECTRONIC DEVICE", which is incorporated herein by reference in its entirety.

### TECHNICAL FIELD

This application relates to the field of electronic device technologies, and in particular, to a hinge mechanism and an electronic device.

### BACKGROUND

With gradual maturation of flexible display technologies, a display manner of an electronic device is driven to greatly change. A mobile phone with a foldable flexible display, a tablet computer with a foldable flexible display, a wearable electronic device with a foldable flexible display, and the like are an important evolution direction of intelligent electronic devices in the future.

As a key component for implementing folding and unfolding functions of a foldable electronic device, a hinge mechanism may be configured to change a folding state of the electronic device, and may further enable, by using a specific structure design, two housings of the electronic device to rotate synchronously, thereby improving reliability of movement of the hinge mechanism, and reducing instantaneous acting force applied by the two housings to a flexible display. However, as the electronic device continues to become lighter and thinner, the hinge mechanism also needs to be correspondingly thinned to match a thin electronic device. However, a mechanical part configured to implement a synchronization function in the current hinge mechanism is usually large in size, and can barely adapt to a development trend of lightness and thinness of the hinge mechanism and even the electronic device.

### SUMMARY

This application provides a hinge mechanism and an electronic device, to improve reliability of movement of the hinge mechanism and reduce a size of the hinge mechanism.

According to a first aspect, this application provides a hinge mechanism. The hinge mechanism includes a base, a first rotating component, a second rotating component, and a synchronization component, where the first rotating component and the second rotating component may be respectively disposed on two opposite sides of the base. The first rotating component includes a first swing arm, and the first swing arm is rotatably connected to the base. The second rotating component includes a second swing arm, and the second swing arm is rotatably connected to the base. The synchronization component includes a first driving arm, a second driving arm, a first sliding block, and a second sliding block. One end of the first driving arm is rotatably connected to an end that is of the first swing arm and that is close to the base, another end of the first driving arm is rotatably connected to the first sliding block, and the first sliding block is slidably disposed on the base in a first direction. One end of the second driving arm is rotatably connected to an end that is of the second swing arm and that is close to the base, another end of the second driving arm is rotatably connected to the second sliding block, and the second sliding block is slidably disposed on the base in the first direction. The first sliding block and the second sliding block are spaced in an axial direction of the hinge mechanism, and the first sliding block is in transmission connection to the second sliding block.

In this application, in a process of unfolding or folding the hinge mechanism, based on a transmission connection relationship between the first sliding block and the second sliding block, the first sliding block and the second sliding block can synchronously slide. Therefore, the first driving arm and the second driving arm can also synchronously rotate, further, the first swing arm connected to the first driving arm and the second swing arm connected to the second driving arm can synchronously rotate toward or away from each other, and rotation angles of the two swing arms may be consistent. In this way, in a process in which the two swing arms synchronously rotate, the first rotating component and the second rotating component can also synchronously rotate toward or away from each other relative to the base. This not only improves reliability of movement of the hinge mechanism, but also reduces instantaneous acting force applied to a flexible display. This helps improve reliability of the flexible display. In addition, compared with a conventional manner in which synchronization is implemented by using a plurality of transmission gears, in this application, space occupied by the synchronization component in a thickness direction of the hinge mechanism can be significantly reduced, thereby helping implement a light and thin design of an electronic device.

In some implementation solutions, the first direction may be perpendicular to the axial direction of the hinge mechanism, that is, the first direction may be a width direction of the hinge mechanism. This design helps further reduce a size of the synchronization component, and reduce layout difficulty of the synchronous component on the hinge mechanism.

In some implementation solutions, a first guiding groove and a second guiding groove may be disposed on the base, the first guiding groove and the second guiding groove are spaced in the axial direction of the hinge mechanism, the first sliding block may be slidably disposed in the first guiding groove, and the second sliding block may be slidably disposed in the second guiding groove, to improve reliability of movement of the first sliding block and the second sliding block.

In some implementation solutions, the synchronization component may further include a connecting rod, a first slotted hole and a second slotted hole are respectively disposed at two ends of the connecting rod, and the first slotted hole and the second slotted hole may separately extend in a length direction of the connecting rod; a first hinged shaft is disposed on the first sliding block, and the first hinged shaft is disposed in the first slotted hole; a second hinged shaft is disposed on the second sliding block, and the second hinged shaft is disposed in the second slotted hole; and with sliding of the first sliding block and the second sliding block, the first hinged shaft and the second hinged shaft may jointly drive the connecting rod to rotate, the first hinged shaft slides in the first slotted hole, and the second hinged shaft slides in the second slotted hole. In this way, the first sliding block and the second sliding block can synchronously slide toward or away from each other through the connecting rod, thereby implementing synchronous rotation of the first rotating component and the second rotating component.

In some implementation solutions, a third hinged hole may be further disposed on the connecting rod, the third hinged hole is located between the first slotted hole and the second slotted hole, and a distance between the third hinged hole and a center of the first slotted hole is equal to a distance between the third hinged hole and a center of the second slotted hole; and a third hinged shaft is disposed on the base, and the third hinged shaft may be rotatably disposed in the third hinged hole, so that the connecting rod is rotatably connected to the base, to improve stability of movement of the connecting rod, and further improve reliability of the transmission connection between the first sliding block and the second sliding block.

In some implementation solutions, the synchronization component may further include an intermediate gear; a first rack is disposed on a side that is of the first sliding block and that faces the second sliding block, and a second rack is disposed on a side that is of the second sliding block and that faces the first sliding block; and the intermediate gear is located between the first sliding block and the second sliding block, and the intermediate gear is separately meshed with the first rack and the second rack. In this way, the first sliding block and the second sliding block can synchronously slide toward or away from each other through the intermediate gear.

In some implementation solutions, in addition to the first swing arm, the first rotating component may further include a first support arm, a first housing support, and a first door plate, the first door plate has a first support surface used to support a flexible display, the first swing arm and the first support arm are disposed on a surface that is of the first door plate and that is away from the first support surface, the first swing arm is fastened to the first door plate, the first support arm is rotatably connected to the base, a rotation axis of the first support arm is parallel to and does not coincide with a rotation axis of the first swing arm, the first housing support is rotatably connected to the first swing arm and the first door plate separately, and the first housing support is slidably connected to the first support arm. Similarly, in addition to the second swing arm, the second rotating component may further include a second support arm, a second housing support, and a second door plate, the second door plate has a second support surface used to support the flexible display, the second swing arm and the second support arm are disposed on a surface that is of the second door plate and that is away from the second support surface, the second swing arm is fastened to the second door plate, the second support arm is rotatably connected to the base, a rotation axis of the second support arm is parallel to and does not coincide with a rotation axis of the second swing arm, the second housing support is rotatably connected to the second swing arm and the second door plate separately, and the first housing support is slidably connected to the first support arm.

When the first housing support and the second housing support rotate toward each other, the first housing support may drive the first swing arm, the first support arm, and the first door plate to rotate around the base, so that a side that is of the first door plate and that is close to the base moves in a direction away from the base; the second housing support may drive the second swing arm, the second support arm, and the second door plate to rotate around the base, so that a side that is of the second door plate and that is close to the base moves in a direction away from the base; and when the first door plate rotates to a first position and the second door plate rotates to a second position, the first door plate and the second door plate form an included angle, and the first door plate, the second door plate, and the base jointly enclose display accommodation space used to accommodate the flexible display. Compared with a solution of three door plates or a plurality of door plates, in this application, the hinge mechanism can effectively reduce a bent transition region in formed display accommodation space, thereby reducing squeezing on the flexible display and improving reliability of the flexible display.

In some implementation solutions, the base has a first surface disposed on a same side as the first support surface and the second support surface, and a groove disposed in the axial direction of the hinge mechanism is disposed on the first surface of the base; and when the hinge mechanism is in an unfolded state, the first door plate and the second door plate each may cover at least a part of a region of the groove; but when the hinge mechanism is in a folded state, the first door plate and the second door plate can expose the groove, and the groove forms a part of the display accommodation space. According to this design, the groove can effectively avoid a bent region of the flexible display, reduce a risk that the flexible display is squeezed, and prolong a service life of the flexible display.

For example, a bottom surface of the groove may be an arc-shaped surface, and the arc-shaped surface protrudes away from the display accommodation space. In this way, the display accommodation space formed by the hinge mechanism can better match a form of the flexible display in a bent state, thereby further reducing the risk that the flexible display is squeezed.

In some implementation solutions, a first arc-shaped groove and a second arc-shaped groove may be respectively disposed on two sides of the base; a first arc-shaped rotation block is disposed on a side that is of the first swing arm and that is close to the base, and the first arc-shaped rotation block is disposed in the first arc-shaped groove and may slide along the first arc-shaped groove, to implement a rotatable connection between the first swing arm and the base; and a second arc-shaped rotation block is disposed on a side that is of the second swing arm and that is close to the base, and the second arc-shaped rotation block is disposed in the second arc-shaped groove and may slide along the second arc-shaped groove, to implement a rotatable connection between the second swing arm and the base.

In some implementation solutions, two ends of the first arc-shaped groove and two ends of the second arc-shaped groove may separately penetrate the base; and when the hinge mechanism is in the unfolded state, an end surface of an end that is of the first arc-shaped rotation block and that is close to the base may extend out of the first arc-shaped groove and be flush with the first support surface, and an end surface of an end that is of the second arc-shaped rotation block and that is close to the base may extend out of the second arc-shaped groove and be flush with the second support surface, to jointly provide flat support for the flexible display with the first door plate and the second door plate.

In some implementation solutions, a third arc-shaped groove is disposed on the first housing support, a third arc-shaped rotation block is disposed at an end that is of the first swing arm and that is away from the base, and the third arc-shaped rotation block is disposed in the third arc-shaped groove and may slide along the third arc-shaped groove, to implement a rotatable connection between the first swing arm and the first housing support; and similarly, a fourth arc-shaped groove is disposed on the second housing support, a fourth arc-shaped rotation block is disposed at an end that is of the second swing arm and that is away from the base, and the fourth arc-shaped rotation block is disposed in the fourth arc-shaped groove and may slide along the fourth arc-shaped groove, to implement a rotatable connection between the second swing arm and the second housing support.

In some implementation solutions, a first sliding groove is disposed on the first housing support, in a direction away from the base, a groove bottom of the first sliding groove may gradually incline in a direction close to the first support surface, and the first support arm is disposed in the first sliding groove and may slide along the first sliding groove, to implement a slidable connection between the first support arm and the first housing support; and similarly, a second sliding groove is disposed on the second housing support, in a direction away from the base, a groove bottom of the second sliding groove may gradually incline in a direction close to the second support surface, and the second support arm is disposed in the second sliding groove and may slide along the groove bottom of the second sliding groove, to implement a slidable connection between the second support arm and the second housing support.

In some implementation solutions, a fifth arc-shaped groove is disposed on the first housing support, a fifth arc-shaped rotation block is disposed on the surface that is of the first door plate and that is away from the first support surface, and the fifth arc-shaped rotation block is disposed in the fifth arc-shaped groove and may rotate along the fifth arc-shaped groove, to implement a rotatable connection between the first door plate and the first housing support; and similarly, a sixth arc-shaped groove is disposed on the second housing support, a sixth arc-shaped rotation block is disposed on the surface that is of the second door plate and that is away from the second support surface, and the sixth arc-shaped rotation block is disposed in the sixth arc-shaped groove and may rotate along the sixth arc-shaped groove, to implement a rotatable connection between the second door plate and the second housing support.

In some implementation solutions, a first limiting wall is disposed on the first housing support, and the first limiting wall and the first support arm are spaced in the axial direction of the hinge mechanism; and the hinge mechanism further includes a first damping component, and the first damping component may be disposed between the first support arm and the first limiting wall, and the first damping component includes a first cam, a second cam, and a first elastic member, where the first cam is disposed on a side that is of the first support arm and that faces the first limiting wall; the second cam is disposed on a side that is of the first cam and that is away from the first support arm, and a cam surface of the second cam presses against a cam surface of the first cam; the first elastic member is disposed on a side that is of the second cam and that is away from the first cam, and the first elastic member is limited between the second cam and the first limiting wall. In the process of unfolding or folding the hinge mechanism, the first damping component may provide specific damping force for the first rotating component and the second rotating component, so that the first rotating component and the second rotating component can stably rotate under the action of the damping force. This prevents the electronic device from being unfolded or folded by mistake, thereby improving user experience.

In some implementation solutions, a first limiting groove disposed in the axial direction of the hinge mechanism is disposed on the first housing support, the first limiting groove has a first opening disposed toward the first support arm, and a bottom wall that is in the first limiting groove and that is disposed opposite to the first opening may form the first limiting wall; and the first elastic member is disposed in the first limiting groove, at least a part of the second cam is disposed in the first limiting groove, and the cam surface of the second cam presses against the cam surface of the first cam through the first opening. This design can improve structural stability and reliability of the first damping component, and help improve structural compactness of the hinge mechanism.

In some implementation solutions, the first cam may be fastened to a side surface of the first support arm in a manner like bonding, welding, or the like.

In some other implementation solutions, the first cam and the first support arm may be of an integrated structure. This helps simplify manufacturing and assembly processes of the hinge mechanism.

In some implementation solutions, the first elastic member may be a spring. The first damping component may further include a first guiding column. The first guiding column may be fastened to the side that is of the second cam and that is away from the first cam, and extend in the axial direction of the hinge mechanism. The spring may be sleeved on a corresponding first guiding column, to reduce a risk of displacement of the spring when elastic deformation occurs.

According to a second aspect, this application further provides an electronic device. The electronic device may include a first housing, a second housing, a flexible display, and the hinge mechanism according to any implementation solution of the first aspect. The first housing and the second housing may be respectively disposed on two sides of the hinge mechanism, the first housing is fastened to the first housing support, and the second housing is fastened to the second housing support; and the flexible display may continuously cover the first door plate, the second door plate, and the hinge mechanism, and the flexible display is fastened to the first door plate and the second door plate.

According to the electronic device provided in this application, in a process of unfolding or folding the electronic device, the first rotating component and the second rotating component can synchronously rotate toward or away from each other relative to the base, so that the first housing and the second housing can also synchronously rotate toward or away from each other. This can not only improve unfolding and folding reliability of the electronic device, but also reduce instantaneous acting force applied to the flexible display. This helps improve reliability of the flexible display.

### BRIEF DESCRIPTION OF DRAWINGS

FIG. 1 is a diagram of a structure of an electronic device according to an embodiment of this application;
FIG. 2 is a diagram of a structure of the electronic device shown in FIG. 1 in an unfolded state;
FIG. 3 is a diagram of a partially exploded structure of the electronic device shown in FIG. 2;
FIG. 4 is a diagram of a structure of a main hinge module according to an embodiment of this application;
FIG. 5 is a diagram of an exploded structure of the main hinge module shown in FIG. 4;
FIG. 6 is a diagram of a structure of a first swing arm according to an embodiment of this application;
FIG. 7 is a diagram of a structure of a first housing support according to an embodiment of this application;
FIG. 8 is a diagram of a structure of a first support arm according to an embodiment of this application;
FIG. 9 is a diagram of a partial structure of a first door plate according to an embodiment of this application;
FIG. 10 is a diagram of a partial structure of a hinge mechanism in an unfolded state according to an embodiment of this application;
FIG. 11 is a diagram of a partial structure of a hinge mechanism in an intermediate state according to an embodiment of this application;
FIG. 12 is a diagram of a partial structure of a hinge mechanism in a folded state according to an embodiment of this application;
FIG. 13 is a diagram of a structure of a synchronization component according to an embodiment of this application;
FIG. 14 is a diagram of an exploded structure of the synchronization component shown in FIG. 13;
FIG. 15 is a diagram of a planar structure of another synchronization component according to an embodiment of this application;
FIG. 16 is a diagram of a structure of a first damping component from a perspective according to an embodiment of this application;
FIG. 17 is a diagram of a structure of a first damping component from another perspective according to an embodiment of this application; and
FIG. 18 is a diagram of an exploded structure of the first damping component shown in FIG. 16.

Reference numerals:
1: hinge; 1a: appearance surface of a hinge mechanism; 1b: support surface of a hinge mechanism; 11: main hinge module; 111: first rotating component;
1111: first swing arm; 11111: first arc-shaped rotation block; 11112: first extension arm; 11113: third arc-shaped rotation block;
11114: protrusion; 1112: first support arm; 11121: first sliding plate; 1113: first housing support;
11131: third arc-shaped groove; 11132: first sliding groove; 111321: first sliding groove; 11133: fifth arc-shaped groove;
11134: first limiting wall; 11135: first limiting groove; 111351: first opening; 1114: first door plate;
11141: first support surface; 11142: hole; 11143: fifth arc-shaped rotation block; 112: second rotating component;
1121: second swing arm; 11211: second arc-shaped rotation block; 11213: fourth arc-shaped rotation block; 1122: first support arm;
1123: second housing support; 11232: second sliding groove; 11231: fourth arc-shaped groove; 1124: second door plate;
11241: second support surface; 11243: sixth arc-shaped rotation block;
113: synchronization component; 1131: first driving arm; 1132: second driving arm; 1133: first sliding block; 11331: first hinged shaft;
11332: first rack; 1134: second sliding block; 11341: second hinged shaft; 11342: second rack; 1135: connecting rod;
11351: first hinged hole; 11352: second hinged hole; 11353: third hinged hole; 1136: intermediate gear;
114: first damping component; 1141: first cam; 11411: first cam surface; 1142: second cam;
11421: second cam surface; 1143: first elastic member; 115: second damping component;
12: base; 121: positioning hole; 122: first arc-shaped groove; 123: second arc-shaped groove; 124: groove; 125: first avoidance groove;
126: second avoidance groove; 127: first guiding groove; 128: second guiding groove; 129: third hinged shaft;
13: cover plate; 131: accommodation groove; 132: positioning pin;
2: first housing; 2a: appearance surface of a first housing; 2b: support surface of a first housing; 201: first mounting groove;
3: second housing; 3a: appearance surface of a second housing; 3b: support surface of a second housing; and 301: second mounting groove.

### DESCRIPTION OF EMBODIMENTS

To make objectives, technical solutions, and advantages of this application clearer, the following further describes embodiments of this application in detail with reference to accompanying drawings. However, example implementations can be implemented in a plurality of forms, and should not be construed as being limited to the implementations described herein. Same reference numerals in the accompanying drawings indicate same or similar structures, and therefore repeated descriptions thereof are omitted. Words for expressing positions and directions in embodiments of this application are described by using the accompanying drawings as examples. However, changes may be made as required, and all changes shall fall within the protection scope of this application. The accompanying drawings in embodiments this application are merely used to show a relative positional relationship, and do not indicate a true scale.

It should be noted that specific details are described in the following description for ease of understanding this application. However, embodiments of this application can be implemented in a plurality of other manners different from those described herein, and a person skilled in the art can make similar promotion without violating a connotation of embodiments of this application. Therefore, this application is not limited to the following disclosed specific implementations.

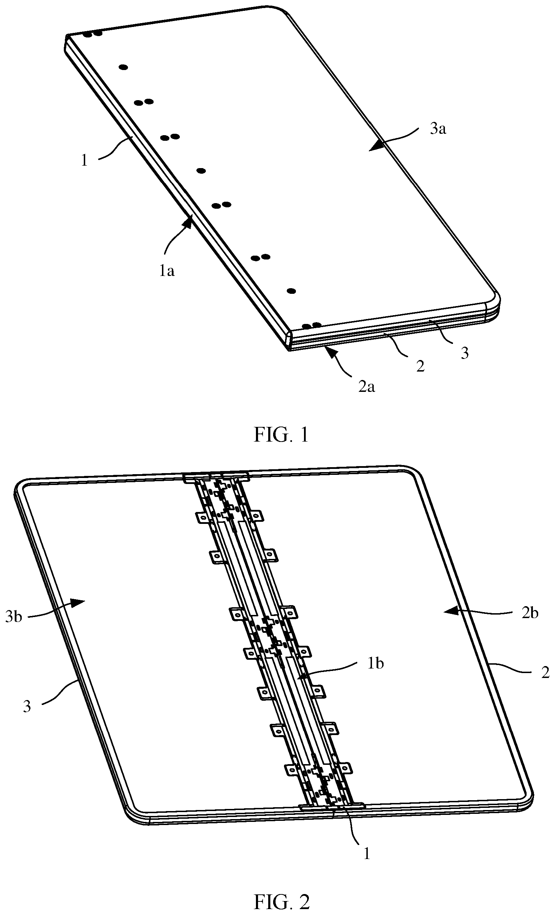

FIG. 1 is a diagram of a structure of an electronic device according to an embodiment of this application. The electronic device may be a mobile phone, a palmtop computer (personal digital assistant, PDA), a notebook computer, a tablet computer, or another device having a foldable function. The electronic device in the embodiment shown in FIG. 1 is described by using the mobile phone as an example. The electronic device may include a hinge mechanism 1, a flexible display (not shown in the figure), and two housings. For ease of description, the two housings may be named as a first housing 2 and a second housing 3 respectively, and the first housing 2 and the second housing 3 are located on two sides of the hinge mechanism 1, and may rotate around the hinge mechanism 1. When the electronic device is used, the electronic device may be folded and unfolded in different usage scenarios. The electronic device provided in this embodiment of this application may be an inwardly foldable electronic device. In the embodiment shown in FIG. 1, the electronic device is in a folded state, and shows a relative position relationship between the hinge mechanism and the two housings when the electronic device is folded. In this case, an appearance surface 1a of the hinge mechanism 1, a first appearance surface 2a of the first housing 2, and a second appearance surface 3a of the second housing 3 may be jointly used as an appearance surface of the electronic device. The appearance surface 1a of the hinge mechanism 1 is a surface that is of the hinge mechanism 1 and that is away from the flexible display, the first appearance surface 2a of the first housing 2 is a surface that is of the first housing 2 and that is away from the flexible display, and the second appearance surface 3a of the second housing 3 is a surface that is of the second housing 3 and that is away from the flexible display.

FIG. 2 is a diagram of a structure of the electronic device shown in FIG. 1 in an unfolded state. FIG. 2 shows structures of a support surface 1b of the hinge mechanism 1, a support surface 2b of the first housing 2, and a support surface 3b of the second housing 3. Herein, the support surface 1b of the hinge mechanism 1 is a surface that is of the hinge mechanism 1 and that is used to support the flexible display, the support surface 2b of the first housing 2 is a surface that is of the first housing 2 and that is used to support the flexible display, and the support surface 3b of the second housing 3 is a surface that is of the second housing 3 and that is used to support the flexible display. The flexible display may continuously cover the support surface 2b of the first housing 2, the support surface 1b of the hinge mechanism, and the support surface 3b of the second housing 3, and the flexible display may be fastened to the support surface 2b of the first housing 2 and the support surface 3b of the second housing 3. A connection manner thereof may be but is not limited to bonding. In this way, when the electronic device is in the unfolded state, the hinge mechanism 1, the first housing 2, and the second housing 3 may support the flexible display. In a process in which the first housing 2 and the second housing 3 rotate relative to each other from the unfolded state to the folded state or from the folded state to the unfolded state, the flexible display may be folded or unfolded with the first housing 2 and the second housing 3.

In the process in which the first housing 2 and the second housing 3 rotate relative to each other from the unfolded state shown in FIG. 2 to the folded state shown in FIG. 1, or from the folded state shown in FIG. 1 to the unfolded state shown in FIG. 2, the flexible display may be folded or unfolded with the first housing 2 and the second housing 3.

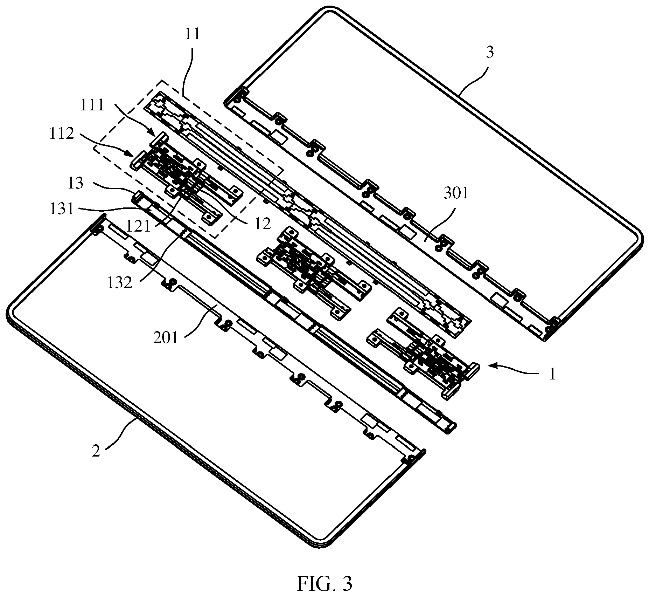

FIG. 3 is a diagram of a partially exploded structure of the electronic device shown in FIG. 2. Refer to FIG. 3. In this embodiment of this application, a first mounting groove 201 is disposed on a side that is of the first housing 2 and that is close to the hinge mechanism 1, and a second mounting groove 301 is disposed on a side that is of the second housing 3 and that is close to the hinge mechanism 1. One side of the hinge mechanism 1 may be partially accommodated in the first mounting groove 201, and another side of the hinge mechanism 1 may be partially accommodated in the second mounting groove 301. The hinge mechanism may include one or more main hinge modules 11. FIG. 3 shows a case in which the hinge mechanism 1 includes three main hinge modules 11, and the three main hinge modules 11 may be spaced in an axial direction of the hinge mechanism 1. The axial direction of the hinge mechanism 1 may be understood as an extension direction of an axis in which the first housing 2 and the second housing 3 rotate around the hinge mechanism 1. The first housing 2 and the second housing 3 may be rotatably connected through the one or more main hinge modules 11. This can effectively improve stability of rotation of the first housing 2 and the second housing 3 of the electronic device relative to the hinge mechanism 1.

In some possible implementation solutions, the hinge mechanism 1 may further include a base 12 disposed in the axial direction, and the base 12 may be configured to bear the one or more main hinge modules 11. When there are a plurality of main hinge modules 11, in an implementation, one base 12 may be used as a bearing component for each of the plurality of main hinge modules 11, to improve integration of the hinge mechanism 1. In another implementation, in the hinge mechanism 1, one base 12 may be correspondingly disposed for each main hinge module 11, so that each main hinge module 11 uses the corresponding base 12 as the bearing component. The embodiment shown in FIG. 3 is described by using an example in which the hinge mechanism 1 includes three bases 12.

The hinge mechanism 1 may further include a cover plate 13, and the cover plate 13 may be disposed on a side that is of the base 12 and that is away from the flexible display. During specific implementation, accommodation grooves 131 that one-to-one correspond to the bases 12 may be disposed on a side that is of the cover plate 13 and that faces the flexible display, and the bases 12 may be disposed in the corresponding accommodation grooves 131. For example, the base 12 may be but is not limited to being bonded and fastened to the corresponding accommodation groove 131 by using adhesive. Optionally, several positioning pins 132 may be further disposed at the bottom of the accommodation groove 131. Correspondingly, positioning holes 121 that one-to-one correspond to the several positioning pins 132 may be disposed on the base 12. When the base 12 is mounted in the accommodation groove 131, the positioning pin 132 at the bottom of the accommodation groove 131 may be disposed in the corresponding positioning hole 121, so that the base 12 is positioned in the accommodation groove 131 through mutual matching between the positioning pin 132 and the positioning hole 121. In addition, a surface of a side that is of the base 12 and that faces the flexible display is defined as a first surface of the base 12. During specific implementation, an end surface of the positioning pin 132 may not exceed the first surface of the base 12, to avoid squeezing on the flexible display.

Refer to FIG. 1 to FIG. 3. When the electronic device is in the unfolded state, a surface that is of the cover plate 13 and that is away from the flexible display may be hidden in the first mounting groove 201 of the first housing 2 and the second mounting groove 301 of the second housing 3. In this case, the appearance surface 2a of the first housing 2 and the appearance surface 3a of the second housing 3 may jointly form the appearance surface of the electronic device. When the electronic device is switched from the unfolded state to the folded state, as the first housing 2 and the second housing 3 rotate, the surface that is of the cover plate 13 and that is away from the flexible display is gradually exposed from the first mounting groove 201 of the first housing 2 and the second mounting groove 301 of the second housing 3. After the electronic device is switched to the folded state, the appearance surface 2a of the first housing 2, the appearance surface 3a of the second housing 3, and the surface that is of the cover plate 13 and that is away from the flexible display jointly form the appearance surface of the electronic device, that is, a surface of a side that is of the cover plate 13 and that is away from the base 12 is a surface that is of the hinge mechanism 1 and that forms the appearance surface of the electronic device.

Still refer to FIG. 3. In this embodiment, the main hinge module 11 may include two rotating components, where the two rotating components are a first rotating component 111 and a second rotating component 112 respectively, and the first rotating component 111 and the second rotating component 112 may be respectively disposed on two opposite sides of the base 12. For ease of description, in the following embodiments of this application, a specific manner of disposing the first rotating component 111 and a connection relationship between the first rotating component 111 and the base 12 are mainly used as examples to describe the main hinge module 11, and the side of the second rotating component 112 may be disposed with reference to the side of the first rotating component 111. It should be noted that a design of the second rotating component 112 may be completely consistent with that of the first rotating component 111. Alternatively, only components and a connection relationship included in the first rotating component 111 may be referenced, and another parameter may be adaptively adjusted, and is not required to be completely consistent.

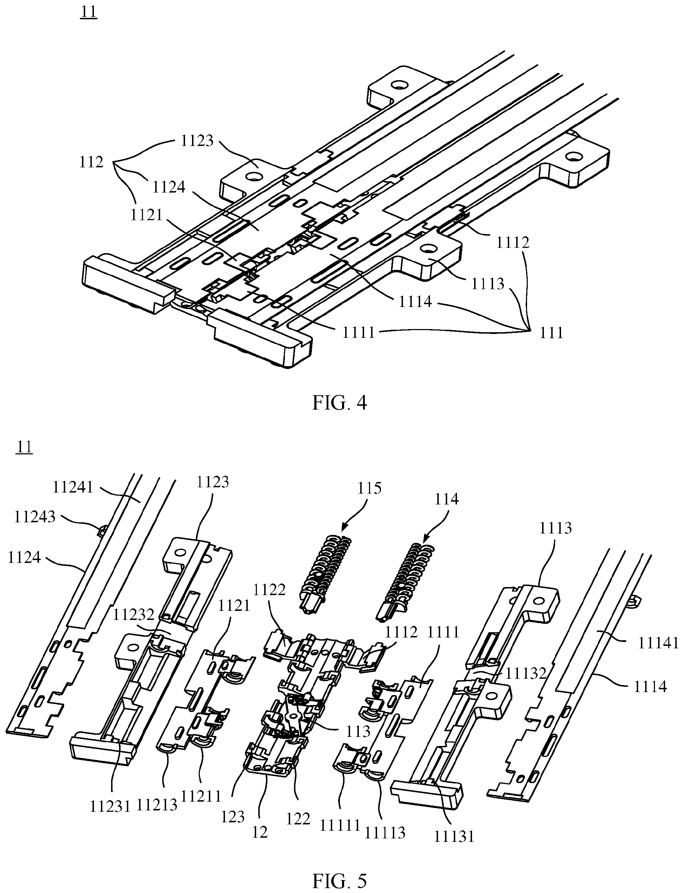

FIG. 4 is a diagram of a structure of the main hinge module 11 according to this embodiment of this application, and FIG. 5 is a diagram of an exploded structure of the main hinge module 11 shown in FIG. 4. Refer to FIG. 4 and FIG. 5. In this embodiment of this application, the first rotating component 111 may include a first swing arm 1111, a first support arm 1112, a first housing support 1113, and a first door plate 1114. The first door plate 1114 may have a first support surface 11141 configured to support the flexible display, and the flexible display may be fastened to the first support surface 11141. The first swing arm 1111 and the first support arm 1112 may be disposed on a surface that is of the first door plate 1114 and that is away from the flexible display, the first swing arm 1111 and the first support arm 1112 are distributed in the axial direction of the hinge mechanism, and are rotatably connected to the base 12 separately, and a rotation axis of the first swing arm 1111 is parallel to and does not coincide with a rotation axis of the first support arm 1112. The first housing support 1113 may be disposed on a surface that is of the first swing arm 1111 and the first support arm 1112 and that is away from the first door plate 1114, the first housing support 1113 may be fastened to the first housing, and the first housing support 1113 may be rotatably connected to the first swing arm 1111, and slidably connected to the first support arm 1112. In addition, the first door plate 1114 may be fastened to the first swing arm 1111, and rotatably connected to the first housing support 1113. Based on the foregoing connection relationship, a slider-crank mechanism may be formed between the first swing arm 1111, the first support arm 1112, and the first housing support 1113, and in processes of unfolding and folding the hinge mechanism, the first housing support 1113 synchronously rotates with the first housing, and further, may drive the first swing arm 1111 and the first support arm 1112 to synchronously rotate around the base 12. In addition, the first door plate 1114 may also rotate based on a specific trajectory under driving of the first housing support 1113 and the first swing arm 1111, to provide flat support for the flexible display in the unfolded state of the hinge mechanism, and jointly provide specific display accommodation space for the flexible display with the second rotating component 112 and the base 12 when the hinge mechanism is in the folded state.

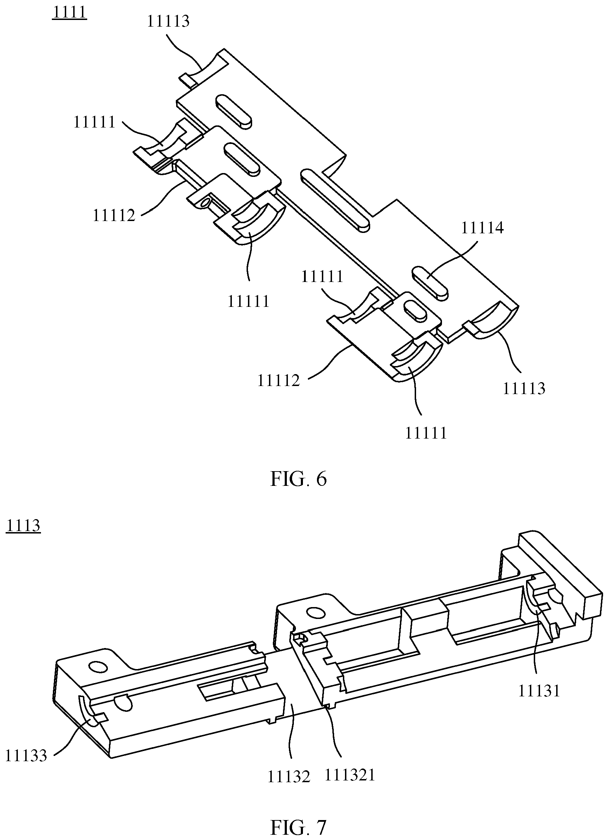

FIG. 6 is a diagram of a structure of the first swing arm 1111 according to this embodiment of this application. Refer to FIG. 5 and FIG. 6. In this embodiment, a first arc-shaped rotation block 11111 may be disposed on a side that is of the first swing arm 1111 and that is close to the base 12, and correspondingly, a first arc-shaped groove 122 may be disposed on the base 12. Two ends of the first arc-shaped groove 122 may separately penetrate the base 12, and the first arc-shaped rotation block 11111 of the first swing arm 1111 may be accommodated in the first arc-shaped groove 122, and may rotate along an arc-shaped surface of the first arc-shaped groove 122, so that the first swing arm 1111 rotates around the base 12, and a rotation center of the first swing arm 1111 is disposed in the axial direction of the hinge mechanism. Such a manner in which the arc-shaped groove matches the arc-shaped rotating block to rotate around an axis center determined by a virtual position may be referred to as a rotatable connection manner of a virtual shaft. In other words, relative rotation is not directly implemented between two rotating entities by using a solid pin shaft, but the rotatable connection is implemented by using the matching structure. This connection manner helps reduce a volume of the main hinge unit, and facilitates a miniaturization design of the hinge mechanism. The first arc-shaped rotation block 11111 may be but is not limited to an arc-shaped rotation block, and the first arc-shaped groove 122 may be but is not limited to an arc-shaped groove.

In a specific embodiment, a first extension arm 11112 may be disposed on the side that is of the first swing arm 1111 and that is close to the base 12, and the first arc-shaped rotation block 11111 may be disposed at an end part of the first extension arm 11112 in the axial direction of the hinge mechanism. For example, there may be one or more first extension arms 11112. For example, the embodiment shown in FIG. 6 shows a case in which the first swing arm 1111 includes two first extension arms 11112, the two first extension arms 11112 are spaced in the axial direction of the hinge mechanism, and one first arc-shaped rotation block 11111 may be disposed at two ends of each first extension arm 11112, that is, four first arc-shaped rotation blocks 11111 are disposed on the first swing arm 1111 in this embodiment. Correspondingly, there may also be four first arc-shaped grooves 122 on the base 12, and the first arc-shaped rotation blocks 11111 are slidably disposed in corresponding first arc-shaped grooves 122 respectively. Stability of movement of the first swing arm 1111 relative to the base 12 can be effectively improved through rotational matching between the plurality of groups of arc-shaped rotation blocks and arc-shaped grooves.

Certainly, in some other embodiments, the first swing arm 1111 may alternatively be rotatably connected to the base 12 by using a pin shaft. In this case, hinged holes may be separately disposed on the first swing arm 1111 and the base 12, and the pin shaft is rotatably disposed in the hinged holes of the first swing arm 1111 and the base 12.

FIG. 7 is a diagram of a structure of the first housing support 1113 according to this embodiment of this application. Refer to FIG. 6 and FIG. 7. In this embodiment, a third arc-shaped rotation block 11113 may be disposed at an end that is of the first swing arm 1111 and that is away from the base 12, a third arc-shaped groove 11131 may be disposed on the first housing support 1113, and the third arc-shaped rotation block 11113 of the first swing arm 1111 may be accommodated in the third arc-shaped groove 11131, and may rotate along an arc-shaped surface of the third arc-shaped groove 11131, to implement a rotatable connection between the first swing arm 1111 and the first housing support 1113.

To improve stability of relative movement between the first swing arm 1111 and the first housing support 1113, there may also be one or more third arc-shaped rotation blocks 11113. The embodiment shown in FIG. 6 shows a case in which the first swing arm 1111 includes two third arc-shaped rotation blocks 11113, and in the axial direction of the hinge mechanism, the two third arc-shaped rotation blocks 11113 may be separately disposed at two ends of the first swing arm 1111. Correspondingly, two third arc-shaped grooves 11131 may be disposed on the first housing support 1113, and the third arc-shaped rotation blocks 11113 are rotatably disposed in corresponding third arc-shaped grooves 11131 respectively.

In addition, in some other implementations, the first swing arm 1111 may alternatively be rotatably connected to the first housing support 1113 by using a pin shaft. Details are not described herein.

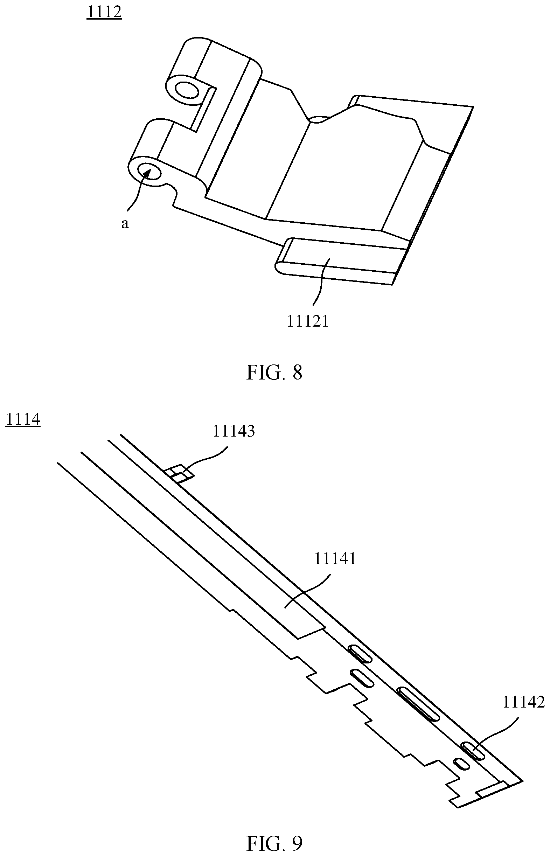

FIG. 8 is a diagram of a structure of the first support arm 1112 according to this embodiment of this application. Refer to FIG. 5 and FIG. 8. In this embodiment of this application, a hinged hole a may be disposed at an end that is of the first support arm 1112 and that is close to the base 12, and correspondingly, a hinged hole (not shown in the figure) may also be disposed on the base. The first support arm 1112 may be rotatably connected to the base 12 by using a pin shaft that is rotatably disposed in the hinged hole a of the first support arm 1112 and the hinged hole of the base 12.

Refer to FIG. 7 and FIG. 8. A first sliding groove 11132 may be disposed on a surface that is of the first housing support 1113 and that faces the first support arm 1112, in a direction away from the base 12, a groove bottom of the first sliding groove 11132 gradually inclines in a direction close to the first support surface 11141 of the first door plate 1114, and a side that is of the first support arm 1112 and that is away from the base may be mounted in the first sliding groove 11132 and may slide in the first sliding groove 11132. In this way, a slidable connection between the first support arm 1112 and the first housing support 1113 is implemented, and an angle of inclination of the groove bottom of the first sliding groove 11132 is properly designed. This can ensure movement coordination of the slider-crank mechanism formed by the first support arm 1112, the first swing arm 1111, and the first housing support 1113, and further, improve reliability of movement of the first rotating component. In addition, to reduce a risk that the first support arm 1112 slides off the first sliding groove 11132, a first sliding rail 111321 may be disposed on a groove wall of the first sliding groove 11132, and correspondingly, a first sliding plate 11121 may be disposed on a side surface of the first support arm 1112, and the first sliding plate 11121 may be slidably disposed in the first sliding rail 111321. In this way, the first support arm 1112 can be limited in the first sliding groove 11132, and the first sliding rail 111321 may also be used to guide sliding of the first support arm 1112 in the first sliding groove 11132, to improve stability of movement of the first support arm 1112.

FIG. 9 is a diagram of a partial structure of the first door plate according to this embodiment of this application. Refer to FIG. 6 and FIG. 9. As described above, the first door plate 1114 is fastened to the first swing arm 1111. During specific implementation, the first door plate 1114 is relatively fastened to the first swing arm 1111 in a manner including but is not limited to welding, bonding, or the like. In addition, several protrusions 11114 may be disposed on a surface that is of the first swing arm 1111 and that faces the first door plate 1114. Correspondingly, holes 11142 that one-to-one correspond to the several protrusions 11114 may be disposed on the first door plate 1114, and when the first swing arm 1111 is fastened to the first door plate 1114, the protrusions 11114 of the first swing arm 1111 may be disposed in corresponding holes 11142 of the first door plate 1114. In this way, assembly and positioning of the first swing arm 1111 and the first door plate 1114 can be implemented through mutual matching between the protrusion 11114 and the hole 11142. In addition, an end surface of the protrusion 11114 of the first swing arm 1111 may not exceed the first support surface of the first door plate 1114, to avoid affecting effect of supporting the flexible display by the first door plate 1114. Optionally, the end surface of the protrusion 11114 of the first swing arm 1111 and the first support surface 11141 of the first door plate 1114 may be disposed on a same plane.

Next, refer to FIG. 7 and FIG. 9. A fifth arc-shaped rotation block 11143 may be disposed on a surface that is of the first door plate 1114 and that is away from the first support surface 11141, and the fifth arc-shaped rotation block 11143 may be located on a side that is of the first door plate 1114 and that is away from the base. Correspondingly, a fifth arc-shaped groove 11133 may be disposed on a side that of the first housing support 1113 and that is away from the base, and the fifth arc-shaped rotation block 11143 of the first door plate 1114 may be accommodated in the fifth arc-shaped groove 11133, and may rotate along an arc-shaped surface of the fifth arc-shaped groove 11133, to implement a rotatable connection between the first door plate 1114 and the first housing support 1113.

In addition, in this embodiment of this application, first door plates 1114 of the plurality of main hinge modules may be separately disposed, or may be of an overall structure. This is not limited in this application. FIG. 9 shows an example in which the first door plates 1114 of the plurality of main hinge modules are integrated. This design helps improve the integration of the hinge mechanism and simplify assembly difficulty of the hinge mechanism.

As described above, the first rotating component 111 and the second rotating component 112 may be respectively disposed on two sides of the base. During specific implementation, refer to FIG. 5 again. The second rotating component 112 may include a second swing arm 1121, a second support arm 1122, a second housing support 1123, and a second door plate 1124. The second door plate 1124 may have a second support surface 11241 configured to support the flexible display. The second swing arm 1121 and the second support arm 1122 are disposed on a surface that is of the second door plate 1124 and that is away from the flexible display, the second swing arm 1121 and the second support arm 1122 are rotatably connected to the base 12 separately, and a rotation axis of the second swing arm 1121 is parallel to and does not coincide with a rotation axis of the second support arm 1122. The second housing support 1123 may be disposed on a surface that is of the second swing arm 1121 and the second support arm 1122 and that is away from the second door plate 1124, and the second housing support 1123 may be fastened to the second housing.

A second arc-shaped rotation block 11211 may be disposed on a side that is of the second swing arm 1121 and that is close to the base 12, correspondingly, a second arc-shaped groove 123 may be disposed on the base 12, and the second arc-shaped rotation block 11211 may be rotatably disposed in the second arc-shaped groove 123, so that the second swing arm 1121 is rotatably connected to the base 12. A fourth arc-shaped rotation block 11213 may be disposed on a side that is of the second swing arm 1121 and that is away from the base 12, correspondingly, a fourth arc-shaped groove 11231 may be disposed on the second housing support 1123, and the fourth arc-shaped rotation block 11213 may be rotatably disposed in the fourth arc-shaped groove 11231, so that the second swing arm 1121 is rotatably connected to the second housing support 1123. In addition, a second sliding groove 11232 may be further disposed on a surface that is of the second housing support 1123 and that faces the second swing arm 1121 and the second support arm 1122, in a direction away from the base 12, a groove bottom of the second sliding groove 11232 gradually inclines in a direction close to the second support surface 11241 of the second door plate 1124, a side that is of the second support arm 1122 and that is away from the base 12 may be slidably disposed in the second sliding groove 11232, and a side that is of the second support arm 1122 and that is close to the base 12 may be rotatably connected to the base 12 by using a pin shaft.

A sixth arc-shaped rotation block 11243 may be disposed on a surface that is of the second door plate 1124 and that is away from the second support surface 11241, and the sixth arc-shaped rotation block 11243 may be located on a side that is of the second door plate 1124 and that is away from the base 12. Correspondingly, a sixth arc-shaped groove (not shown in the figure) may be disposed on a side that of the second housing support 1123 and that is away from the base 12, and the sixth arc-shaped rotation block 11243 of the second door plate 1124 may be slidably disposed the sixth arc-shaped groove, so that the second door plate 1124 is rotatably connected to the second housing support 1123. In addition, second door plates 1124 of the plurality of main hinge modules 11 may be separately disposed, or may be of an overall structure. This is not limited in this application.

After understanding of the structures of the first rotating module 111 and the second rotating module 112 and the connection relationships between the first rotating module 111 and the base 12 and between the second rotating module 112 and the base 12 provided in the foregoing embodiments of this application, the following describes a movement process of the hinge mechanism.

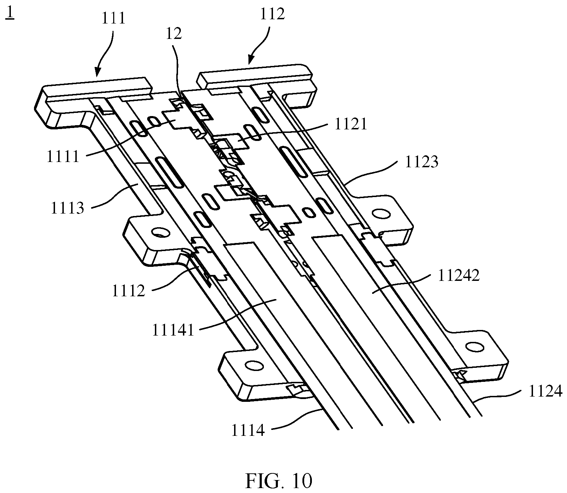

First, FIG. 10 is a diagram of a partial structure of the hinge mechanism 1 in the unfolded state according to this embodiment of this application. When the hinge mechanism 1 is in the unfolded state, the first rotating component 111 and the second rotating component 112 are located on two sides of the base 12, and an included angle between the first rotating component 111 and the second rotating component 112 is approximately 180 degrees. In this case, the first support surface 11141 of the first door plate 1114 and the second support surface 11241 of the second door plate 1124 are disposed on a same plane, and the first door plate 1114 and the second door plate 1124 each cover at least a part of a region of the base 12. In addition, an end surface of an end that is of the first arc-shaped rotation block of the first swing arm 1111 and that is close to the base 12 may extend out of the first arc-shaped groove of the base 12 and be flush with the first support surface 11141, and an end surface of an end that is of the second arc-shaped rotation block of the second swing arm 1121 and that is close to the base 12 may extend out of the second arc-shaped groove of the base 12 and be flush with the second support surface 11241, to jointly provide flat support for the flexible display with the first door plate 1114 and the second door plate 1124.

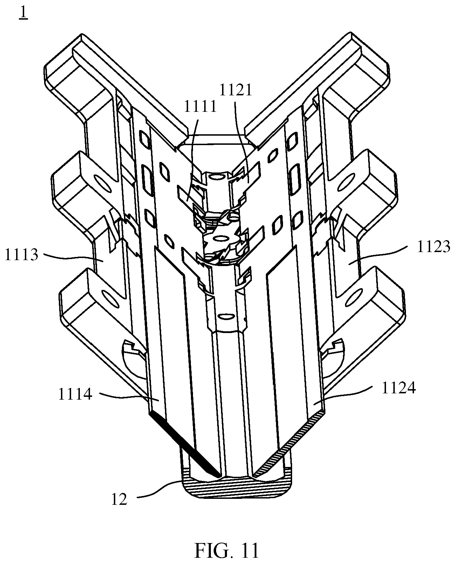

FIG. 11 is a diagram of a partial structure of the hinge mechanism 1 in an intermediate state according to this embodiment of this application. In the process in which the hinge mechanism 1 is switched from the unfolded state to the folded state, the first housing support 1113 rotates clockwise, and drives the first swing arm 1111 and the first support arm to synchronously rotate clockwise, and based on a rotatable connection relationship between the first housing support 1113 and the first door plate 1114 and a fastened connection relationship between the first swing arm 1111 and the first door plate 1114, the first door plate 1114 may also rotate clockwise under driving of the first housing support 1113 and the first swing arm 1111, so that a side that is of the first door plate 1114 and that is close to the base 12 rotates in a direction away from the base 12, and exposes the part of the region of the base 12 covered under the first door plate 1114. Correspondingly, the second housing support 1123 rotates counterclockwise, and drives the second swing arm 1121 and the second support arm to synchronously rotate counterclockwise, and based on a rotatable connection relationship between the second housing support 1123 and the second door plate 1124 and a fastened connection relationship between the second swing arm 1121 and the second door plate 1124, the second door plate 1124 may also rotate counterclockwise under driving of the second housing support 1123 and the second swing arm 1121, so that a side that is of the second door plate 1124 and that is close to the base 12 rotates in a direction away from the base 12, and exposes the part of the region of the base 12 covered under the second door plate 1124.

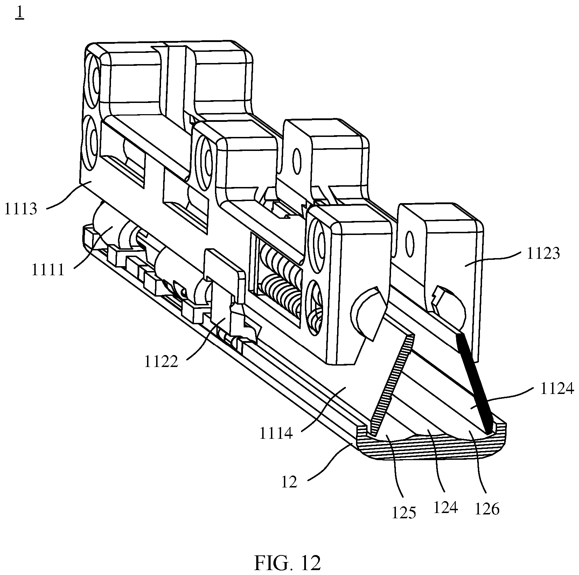

FIG. 12 is a diagram of a partial structure of the hinge mechanism 1 in the folded state according to this embodiment of this application. In a process in which the hinge mechanism 1 is changed from the intermediate state shown in FIG. 11 to the folded state shown in FIG. 12, the first housing support 1113 continues to rotate clockwise, and drives, together with the first swing arm 1111, the first door plate 1114 to rotate clockwise, the second housing support 1123 continues to rotate counterclockwise, and drives, together with the second swing arm 1121, the second door plate 1124 to rotate counterclockwise until the first door plate 1114 rotates to a first position and the second door plate 1124 rotates to a second position, and approximate positions of the first housing support 1113 and the second housing support 1123 are opposite. In this case, the hinge mechanism 1 is switched to the folded state. When the hinge mechanism 1 is in the folded state, the first door plate 1114 and the second door plate 1124 may form an included angle (which may be an acute angle), and jointly enclose display accommodation space approximately in a water drop shape with the base 12.

Still refer to FIG. 12. In this embodiment of this application, a groove 124 may be further disposed on the first surface that is of the base 12 and that faces the flexible display, and the groove 124 may extend in the axial direction of the hinge mechanism 1. When the hinge mechanism 1 is in the folded state, the first surface of the base 12 is exposed from coverage of the first door plate 1114 and the second door plate 1124. In this case, the groove 124 may form a part of the display accommodation space, to effectively avoid a bent region of the flexible display, reduce a risk that the flexible display is squeezed, and prolong a service life of the flexible display. Optionally, a bottom surface of groove 124 may be an arc-shaped surface, and the arc-shaped surface protrudes away from the display accommodation space. According to this design, the display accommodation space formed by the hinge mechanism 1 can better match a form of the flexible display in a bent state, thereby further reducing the risk that the flexible display is squeezed.

It should be noted that, when the hinge mechanism 1 includes a plurality of bases 12, and the plurality of bases 12 are respectively disposed in corresponding accommodation grooves of the cover plate, grooves of a same depth and shape may also be disposed in regions between adjacent accommodation grooves on the cover plate, to connect grooves on adjacent bases 12, and improve shape consistency of the display accommodation space in the axial direction of the hinge mechanism 1, so that the hinge mechanism 1 can effectively avoid the bent region of the flexible display in the entire axial direction.

In addition, a first avoidance groove 125 and a second avoidance groove 126 may be respectively disposed on two sides of the groove 124, and the first avoidance groove 125 and the second avoidance groove 126 separately extend in the axial direction of the hinge mechanism 1. The first avoidance groove 125 may be located on a side that is of the groove 124 and that is close to the first rotating component, so that when the first door plate 1114 rotates, specific avoidance space is provided for the side that is of the first door plate 1114 and that is close to the base 12, and a risk of interference between the first door plate 1114 and the base 12 is reduced. The second avoidance groove 126 may be located on a side that is of the groove 124 and that is close to the second rotating component, so that when the second door plate 1124 rotates, specific avoidance space is provided for the side that is of the second door plate 1124 and that is close to the base 12, and a risk of interference between the second door plate 1124 and the base 12 is reduced.

Similarly, when the hinge mechanism 1 includes a plurality of bases 12, and the plurality of bases 12 are respectively disposed in corresponding accommodation grooves of the cover plate, first avoidance grooves and second avoidance grooves of a same depth and shape may also be disposed in regions between adjacent accommodation grooves on the cover plate, to reduce a risk of interference between the first door plate 1114 and the cover plate and between the second door plate 1124 and the cover plate.

In addition to the foregoing structures, in some embodiments of this application, another possible structure may be further disposed in the hinge mechanism. For example, refer to FIG. 5. To better implement unfolding and folding of the hinge mechanism, a synchronization component 113 that enables the first rotating component 111 and the second rotating component 112 to synchronously rotate may be further disposed in the hinge mechanism. The hinge mechanism may include a synchronization component 113. In this case, the synchronization component 113 may be disposed in one main hinge module 11, and is in transmission connection to the first rotating component 111 and the second rotating component 112 of the main hinge module 11. Alternatively, the hinge mechanism may include a plurality of synchronization components 113. In this case, the plurality of synchronization components 113 may be respectively disposed in different main hinge modules 11, and each synchronization component 113 is in transmission connection to the first rotating component 111 and the second rotating component 112 of a corresponding main hinge module 11.

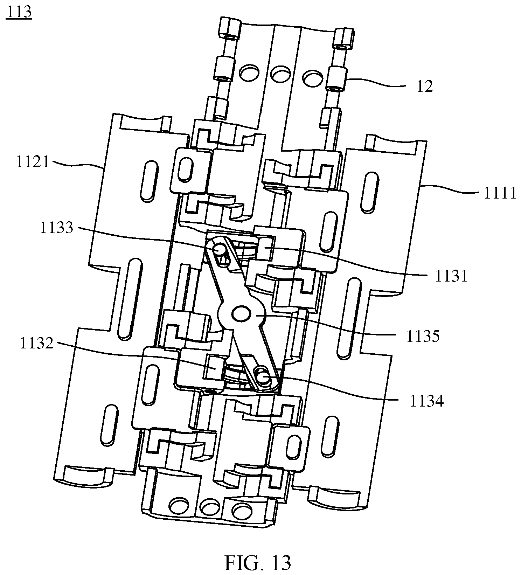

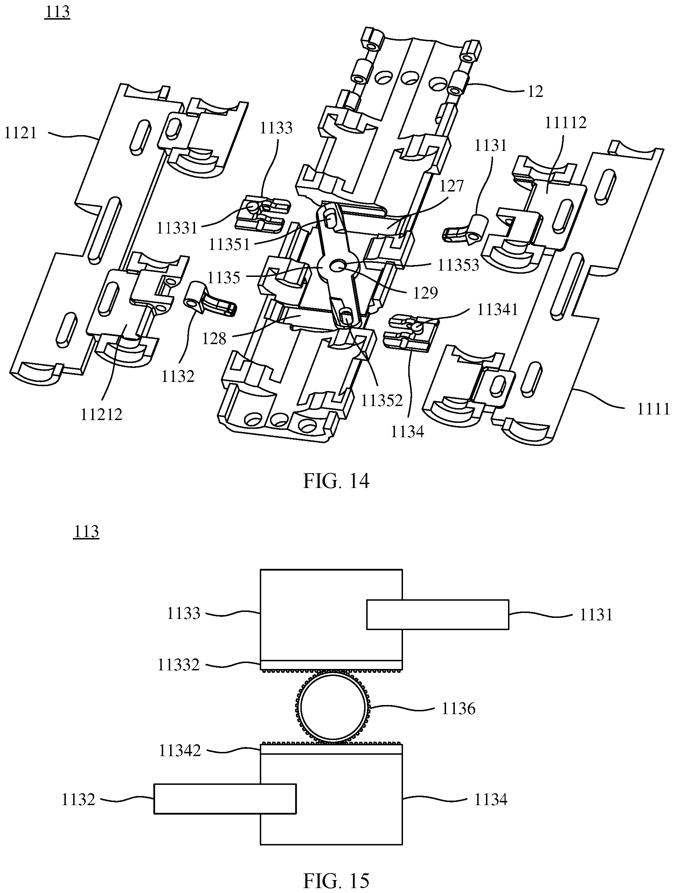

Refer to FIG. 13 and FIG. 14. FIG. 13 is a diagram of a structure of the synchronization component 113 according to this embodiment of this application, and FIG. 14 is a diagram of an exploded structure of the synchronization component 113 shown in FIG. 13. In this embodiment of this application, the synchronization component 113 may include a first driving arm 1131, a second driving arm 1132, a first sliding block 1133, and a second sliding block 1134. One end of the first driving arm 1131 may be rotatably connected to an end that is of the first swing arm 1111 and that is close to the base 12, and another end of the first driving arm 1131 may be slidably connected to the first sliding block 1133. One end of the second driving arm 1132 may be rotatably connected to an end that is of the second swing arm 1121 and that is close to the base 12, and another end of the second driving arm 1132 may be slidably connected to the second sliding block 1134. The first sliding block 1133 and the second sliding block 1134 are slidably disposed on the base 12 separately in a first direction, the first sliding block 1133 and the second sliding block 1134 may be distributed in the axial direction of the hinge mechanism, and the first sliding block 1133 and the second sliding block 1134 are in transmission connection and can slide toward or away from each other. An included angle may be formed between the first direction and the axial direction of the hinge mechanism. For example, the included angle may be approximately 90 degrees, that is, the first direction may be perpendicular to the axial direction of the hinge mechanism.

In the process of unfolding or folding the hinge mechanism, the first sliding block 1133 and the second sliding block 1134 can synchronously slide toward or away from each other. Therefore, the first driving arm 1131 and the second driving arm 1132 can also synchronously rotate, further, the first swing arm 1111 connected to the first driving arm 1131 and the second swing arm 1121 connected to the second driving arm 1132 can synchronously rotate toward or away from each other, and rotation angles of the two swing arms may be consistent. In this way, in a process in which the two swing arms synchronously rotate, the first housing and the second housing of the electronic device can be driven to synchronously rotate, so that instantaneous acting force applied to the flexible display fastened to the two housings can be avoided. This helps improve reliability of the flexible display. In addition, compared with a conventional manner in which synchronization is implemented by using a plurality of transmission gears, in this embodiment, space occupied by the synchronization component 113 in a thickness direction of the hinge mechanism can be significantly reduced, thereby helping implement a light and thin design of the electronic device.

In this embodiment of this application, a first guiding groove 127 and a second guiding groove 128 may be disposed on the first surface of the base 12, the first guiding groove 127 and the second guiding groove 128 are spaced in the axial direction of the hinge mechanism, the first sliding block 1133 may be slidably disposed in the first guiding groove 127, and the second sliding block 1134 may be slidably disposed in the second guiding groove 128. The first driving arm 1131 may be rotatably connected to the first sliding block 1133 by using a pin shaft, and the second driving arm 1132 may also be rotatably connected to the second sliding block 1134 by using a pin shaft.

In addition, the first driving arm 1131 may rotate relative to the first swing arm 1111 by being rotatably connected to the first extension arm 11112 of the first swing arm 1111, and the second driving arm 1132 may rotate relative to the second swing arm 1121 by being rotatably connected to a second extension arm 11212 of the second swing arm 1121. In addition, a rotation axis of the first driving arm 1131 and a rotation axis of the second driving arm 1132 are separately disposed in the axial direction of the hinge mechanism, and the rotation axis of the first driving arm 1131 may coincide or may not coincide with the rotation axis of the first swing arm 1111. Similarly, the rotation axis of the second driving arm 1132 may coincide or may not coincide with the rotation axis of the second swing arm 1121. For example, the first driving arm 1131 may be rotatably connected to the first extension arm 11112 by using a pin shaft, and the second driving arm 1132 may also be rotatably connected to the second extension arm 11212 by using a pin shaft.

Still refer to FIG. 13 and FIG. 14. The synchronization component may further include a connecting rod 1135. One end of the connecting rod 1135 may be rotatably connected to the first sliding block 1133, and another end of the connecting rod 1135 may be rotatably connected to the second sliding block 1134, so that the transmission connection between the first sliding block 1133 and the second sliding block 1134 is implemented through the connecting rod 1135. During specific implementation, the connecting rod 1135 may be located on a side that is of the first sliding block 1133 and the second sliding block 1134 and that faces the flexible display, a first slotted hole 11351 and a second slotted hole 11352 may be respectively disposed at the two ends of the connecting rod 1135, and the first slotted hole 11351 and the second slotted hole 11352 separately extend in a length direction of the connecting rod. A first hinged shaft 11331 may be disposed on the side that is of the first sliding block 1133 and that faces the flexible display, and a second hinged shaft 11341 may be disposed on the side that is of the second sliding block 1134 and that faces the flexible display. The first hinged shaft 11331 may be disposed in the first slotted hole 11351 of the connecting rod 1135, and the second hinged shaft 11341 may be disposed in the second slotted hole 11352 of the connecting rod 1135. With sliding of the first sliding block 1133 and the second sliding block 1134, the first hinged shaft 11331 and the second hinged shaft 11341 may jointly drive the connecting rod 1135 to rotate, and with rotation of the connecting rod 1135, a position of the first hinged shaft 11331 in the first slotted hole 11351 and a position of the second hinged shaft 11341 in the second slotted hole 11352 also change. Alternatively, it may be understood as that the first hinged shaft 11331 slides in the first slotted hole 11351, and the second hinged shaft 11341 slides in the second slotted hole 11352. In this way, the first sliding block 1133 and the second sliding block 1134 can synchronously slide toward or away from each other through the connecting rod 1135, thereby implementing the synchronous rotation of the first housing and the second housing.

For example, when the first sliding block 1133 and the second sliding block 1134 slide toward each other, the first sliding block 1133 and the second sliding block 1134 may jointly drive the connecting rod 1135 to rotate clockwise, the first hinged shaft 11331 slides in the first slotted hole 11351 toward an end close to the second slotted hole 11352, and the second hinged shaft 11341 slides in the second slotted hole 11352 toward an end close to the first slotted hole 11351. When the first sliding block 1133 and the second sliding block 1134 slide away from each other, the first sliding block 1133 and the second sliding block 1134 may jointly drive the connecting rod 1135 to rotate counterclockwise, the first hinged shaft 11331 slides in the first slotted hole 11351 toward an end away from the second slotted hole 11352, and the second hinged shaft 11341 slides in the second slotted hole 11352 toward an end away from the first slotted hole 11351.

In addition, in some possible embodiments, a hinged hole 11353 may be further disposed on the connecting rod 1135. Correspondingly, a third hinged shaft 129 may be disposed on the first surface of the base, and the third hinged shaft 129 may be rotatably disposed in the hinged hole 11353 of the connecting rod 1135, so that the connecting rod 1135 is rotatably connected to the base 12, to improve stability of movement of the connecting rod 1135, and further improve reliability of the transmission connection between the first sliding block 1133 and the second sliding block 1134. During specific disposing, the hinged hole 11353 may be located between the first slotted hole 11351 and the second slotted hole 11352, and a distance between the hinged hole 11353 and a center of the first slotted hole 11351 may be equal to a distance between the hinged hole 11353 and a center of the second slotted hole 11352. In this way, rotation amplitudes at the two ends of the connecting rod 1135 may be approximately equal, and further, sliding distances of the first sliding block 1133 and the second sliding block 1134 may also be approximately equal, thereby improving rotation synchronization of the first housing and the second housing.

In some other embodiments, in addition to being in the transmission connection through the connecting rod 1135, the first sliding block 1133 and the second sliding block 1134 may also be in the transmission connection through gear meshing. For example, FIG. 15 is a diagram of a planar structure of another synchronization component 113 according to an embodiment of this application. In this embodiment, the synchronization component 113 further includes an intermediate gear 1136. In this case, a first rack 11332 may be disposed on a side that is of the first sliding block 1133 and that faces the second sliding block 1134, a second rack 11342 may be disposed on a side that is of the second sliding block 1134 and that faces the first sliding block 1133, the intermediate gear 1136 is located between the first sliding block 1133 and the second sliding block 1134, and the intermediate gear 1136 is separately meshed with the first rack 11332 and the second rack 11342. In this way, the first sliding block 1133 and the second sliding block 1134 can synchronously slide toward or away from each other through the intermediate gear 1136.

Refer to FIG. 5 again. In this embodiment of this application, to better implement the unfolding and folding of the hinge mechanism, a damping component that may provide damping force for the first rotating component 111 and the second rotating component 112 may be further disposed in the hinge mechanism, so that the first rotating component 111 and the second rotating component 112 can stably rotate under the action of the damping force. This prevents the electronic device from being unfolded or folded by mistake, and implements suspension of the two housings in specified positions. The hinge mechanism may include a damping component. In this case, the damping component may be disposed corresponding to the first rotating component 111 or the second rotating component 112 of one main hinge module. Alternatively, the hinge mechanism may include a plurality of damping components. In this case, the plurality of damping components may be disposed corresponding to the first rotating component 111 and the second rotating component 112 of at least one main hinge module 11. For example, FIG. 5 shows a case in which each main hinge module 11 includes two damping components. For ease of distinguishing, the damping component disposed corresponding to the first rotating component 111 is referred to as a first damping component 114, and the damping component disposed corresponding to the second rotating component 112 is referred to as a second damping component 115 below. The following mainly uses a manner of disposing the first damping component 114 and a connection relationship between the first damping component 114 and the first rotating component 111 as an example to describe the first damping component 114. The second damping component 115 may be disposed with reference to the first damping component 114.

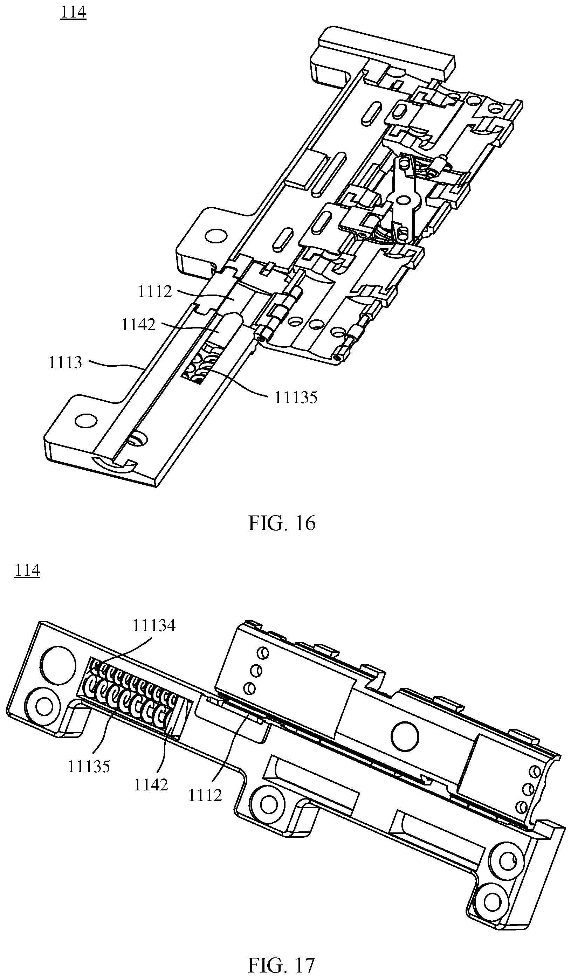

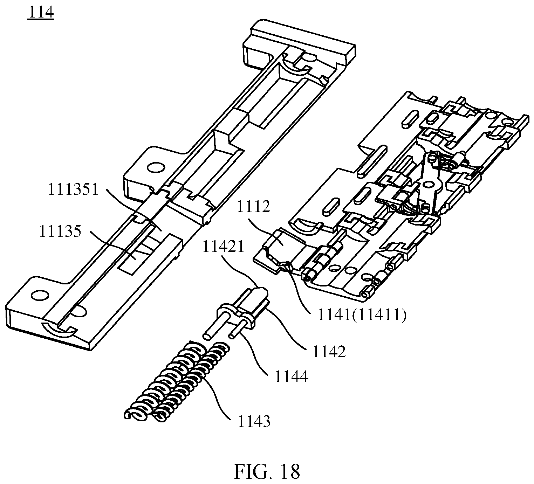

Refer to FIG. 16 to FIG. 18. FIG. 16 is a diagram of a structure of the first damping component 114 from a perspective according to this embodiment of this application, FIG. 17 is a diagram of a structure of the first damping component 114 from another perspective according to this embodiment of this application, and FIG. 18 is a diagram of an exploded structure of the first damping component 114 shown in FIG. 16. In this embodiment of this application, a first limiting wall 11134 may be disposed on the first housing support 1113, the first limiting wall 11134 and the first support arm 1112 may be spaced in the axial direction of the hinge mechanism, and the first damping component 114 may be disposed between the first limiting wall 11134 and the first support arm 1112. During specific implementation, when the first limiting wall 11134 is formed, a first limiting groove 11135 disposed in the axial direction of the hinge mechanism may be disposed on the first housing support 1113, the first limiting groove 11135 has a first opening 111351 disposed toward the first support arm, and in this case, a bottom wall that is of the first limiting groove 11135 and that is disposed opposite to a side on which the first opening 111351 is located may form the first limiting wall 11134.

The first damping component 114 may include a first cam 1141, a second cam 1142, and a first elastic member 1143. The first cam 1141 may be disposed on a side that is of the first support arm 1112 and that faces the first limiting wall 11134, and a first cam surface 11411 is disposed on a side that is of the first cam 1141 and that faces the first limiting wall 11134. The second cam 1142 may be disposed on a side that is of the first cam 1141 and that faces the first support arm 1112, and a second cam surface 11421 is disposed on a side that is of the second cam 1142 and that faces the first cam 1141. The first elastic member 1143 may be limited between the second cam 1142 and the first limiting wall 11134, to apply elastic force to the second cam 1142, so that the second cam surface 11421 of the second cam 1142 presses against the first cam surface 11411 of the first cam 1141.

In some embodiments, the first cam 1141 may be fastened to the side surface of the first support arm 1112 in a manner like bonding, welding, or the like. In some other embodiments, the first cam 1141 and the first support arm 1112 may alternatively be of an integrally formed structure, or it may be understood as that the first cam surface 11411 may be directly formed on a side surface that is of the first support arm 1112 and that faces the first limiting wall 11134. This helps simplify manufacturing and assembly processes of the hinge mechanism. In addition, when the first limiting groove 11135 is disposed on the first housing support 1113, the first elastic member 1143 may be disposed in the first limiting groove 11135, and at least a part of the second cam 1142 may be disposed in the first limiting groove 11135, so that the first limiting groove 11135 limits a movement direction of the second cam 1142 driven by the first elastic member 1143, thereby improving structural stability and reliability of the first damping component 114. In this case, the second cam surface 11421 of the second cam 1142 may press against the first cam surface 11411 of the first cam 1141 through the first opening 111351.

Optionally, the first elastic member 1143 may be a spring shown in FIG. 18. A quantity of springs may be set based on a magnitude of damping force that needs to be provided by the first damping component 114, space of the hinge mechanism, and the like. FIG. 18 shows a case of two springs, and the two springs may be disposed in parallel between the second cam 1142 and the first limiting wall 11134. In addition, the first damping component 114 may further include a first guiding column 1144 corresponding to each spring. The first guiding column 1144 may be fastened to the side that is of the second cam 1142 and that is away from the first cam 1141, and extend in the axial direction of the hinge mechanism. The spring may be sleeved on a corresponding first guiding column 1144, to reduce a risk of displacement of the spring when elastic deformation occurs. For example, the first guiding column 1144 and the second cam 1142 may be of an integrated structure, to simplify manufacturing and assembly processes of the first damping component 114.

Certainly, in some other implementations, the first elastic member 1143 may alternatively be a spring plate, there may be a plurality of spring plates, and the plurality of spring plates may be stacked between the second cam 1142 and the first limiting wall 11134.

Still refer to FIG. 16 to FIG. 18. In this embodiment of this application, both the first cam surface 11411 and the second cam surface 11421 may include a plurality of protrusion parts and concave parts. When slopes of the protrusion parts of the two cam surfaces are in contact with each other, damping force that prevents the two cam surfaces from continuing to rotate relative to each other may be generated between the two cam surfaces. Curved surface outlines of the first cam surface 11411 and the second cam surface 11421 are properly designed, so that in the process of folding the hinge mechanism, with rotation of the first support arm 1112, the first cam 1141 can push the second cam 1142 to a direction close to the first limiting wall 11134, to compress the first elastic member 1143, so that the user obtains an obvious tactile feeling of performing an operation. This helps improve user experience. In a process of unfolding the hinge mechanism, the first elastic member 1143 gradually rebounds from a compressed state, and releases accumulated elastic potential energy, to push the second cam 1142 to slide in a direction close to the first cam 1141. In this way, the second cam 1142 can apply, to the first cam 1141 and the first support arm 1112, torque force that helps the first cam 1141 and the first support arm 1112 rotate, to provide specific unfolding assistance for the hinge mechanism, thereby reducing unfolding operation difficulty of the hinge mechanism.

In addition, in this embodiment of this application, the first cam surface 11411 and the second cam surface 11421 are properly designed, so that the first cam 1141 can be suspended at a specified angle, that is, the first support arm 1112 is suspended. When the hinge mechanism is used in the electronic device, the electronic device may be positioned in some intermediate states by using a suspendable design of the first support arm 1112, thereby further improving user experience.

The descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism, comprising a base, a first rotating component, a second rotating component, and a synchronization component, wherein the first rotating component and the second rotating component are respectively disposed on two sides of the base;
the first rotating component comprises a first swing arm, and the first swing arm is rotatably connected to the base;
the second rotating component comprises a second swing arm, and the second swing arm is rotatably connected to the base; and
the synchronization component comprises a first driving arm, a second driving arm, a first sliding block, and a second sliding block, one end of the first driving arm is rotatably connected to an end that is of the first swing arm and that is close to the base, another end of the first driving arm is rotatably connected to the first sliding block, the first sliding block is slidably disposed on the base in a first direction, one end of the second driving arm is rotatably connected to an end that is of the second swing arm and that is close to the base, another end of the second driving arm is rotatably connected to the second sliding block, the second sliding block is slidably disposed on the base in the first direction, the first sliding block and the second sliding block are spaced in an axial direction of the hinge mechanism, the first sliding block is in transmission connection to the second sliding block, and an included angle is formed between the first direction and the axial direction of the hinge mechanism.

2. The hinge mechanism according to claim 1, wherein the synchronization component further comprises a connecting rod, a first slotted hole and a second slotted hole are respectively disposed at two ends of the connecting rod, and the first slotted hole and the second slotted hole separately extend in a length direction of the connecting rod;
a first hinged shaft is disposed on the first sliding block, and the first hinged shaft is disposed in the first slotted hole;
a second hinged shaft is disposed on the second sliding block, and the second hinged shaft is disposed in the second slotted hole; and
with sliding of the first sliding block and the second sliding block, the first hinged shaft and the second hinged shaft jointly drive the connecting rod to rotate, the first hinged shaft slides in the first slotted hole, and the second hinged shaft slides in the second slotted hole.

3. The hinge mechanism according to claim 2, wherein a hinged hole is further disposed on the connecting rod, the hinged hole is located between the first slotted hole and the second slotted hole, and a distance between the hinged hole and a center of the first slotted hole is equal to a distance between the hinged hole and a center of the second slotted hole; and
a third hinged shaft is disposed on the base, and the third hinged shaft is rotatably disposed in the hinged hole.

4. The hinge mechanism according to claim 1, wherein the synchronization component further comprises an intermediate gear;
a first rack is disposed on a side that is of the first sliding block and that faces the second sliding block, and a second rack is disposed on a side that is of the second sliding block and that faces the first sliding block; and
the intermediate gear is located between the first sliding block and the second sliding block, and the intermediate gear is separately meshed with the first rack and the second rack.

5. The hinge mechanism according to any one of claims 1 to 4, wherein the first rotating component further comprises a first support arm, a first housing support, and a first door plate, the first door plate has a first support surface used to support a flexible display, the first swing arm and the first support arm are disposed on a surface that is of the first door plate and that is away from the first support surface, the first swing arm is fastened to the first door plate, the first support arm is rotatably connected to the base, a rotation axis of the first support arm is parallel to and does not coincide with a rotation axis of the first swing arm, the first housing support is rotatably connected to the first swing arm and the first door plate separately, and the first housing support is slidably connected to the first support arm;
the second rotating component comprises a second support arm, a second housing support, and a second door plate, the second door plate has a second support surface used to support the flexible display, the second swing arm and the second support arm are disposed on a surface that is of the second door plate and that is away from the second support surface, the second swing arm is fastened to the second door plate, the second support arm is rotatably connected to the base, a rotation axis of the second support arm is parallel to and does not coincide with a rotation axis of the second swing arm, the second housing support is rotatably connected to the second swing arm and the second door plate separately, and the second housing support is slidably connected to the second support arm; and
when the first housing support and the second housing support rotate toward each other, the first housing support drives the first swing arm, the first support arm, and the first door plate to rotate around the base, so that a side that is of the first door plate and that is close to the base moves in a direction away from the base; when the second housing support drives the second swing arm, the second support arm, and the second door plate to rotate around the base, a side that is of the second door plate and that is close to the base moves in a direction away from the base; and when the first door plate rotates to a first position and the second door plate rotates to a second position, the first door plate and the second door plate form an included angle, and the first door plate, the second door plate, and the base jointly enclose display accommodation space used to accommodate the flexible display.

6. The hinge mechanism according to claim 5, wherein the base has a first surface disposed on a same side as the first support surface and the second support surface, and a groove disposed in the axial direction of the hinge mechanism is disposed on the first surface of the base; and
when the hinge mechanism is in an unfolded state, the first door plate and the second door plate each cover at least a part of a region of the groove; or
when the hinge mechanism is in a folded state, the first door plate and the second door plate expose the groove, and the groove forms a part of the display accommodation space.

7. The hinge mechanism according to claim 6, wherein a bottom surface of the groove is an arc-shaped surface, and the arc-shaped surface protrudes away from the display accommodation space.

8. The hinge mechanism according to any one of claims 5 to 7, wherein a first arc-shaped groove and a second arc-shaped groove are respectively disposed on two sides of the base;
a first arc-shaped rotation block is disposed on a side that is of the first swing arm and that is close to the base, and the first arc-shaped rotation block is disposed in the first arc-shaped groove and is configured to implement a rotatable connection between the first swing arm and the base; and
a second arc-shaped rotation block is disposed on a side that is of the second swing arm and that is close to the base, and the second arc-shaped rotation block is disposed in the second arc-shaped groove and is configured to implement a rotatable connection between the second swing arm and the base.

9. The hinge mechanism according to claim 8, wherein two ends of the first arc-shaped groove and two ends of the second arc-shaped groove separately penetrate the base; and
when the hinge mechanism is in the unfolded state, an end surface of an end that is of the first arc-shaped rotation block and that is close to the base extends out of the first arc-shaped groove and is flush with the first support surface, and an end surface of an end that is of the second arc-shaped rotation block and that is close to the base extends out of the second arc-shaped groove and is flush with the second support surface.

10. The hinge mechanism according to any one of claims 5 to 9, wherein a third arc-shaped groove is disposed on the first housing support, a third arc-shaped rotation block is disposed at an end that is of the first swing arm and that is away from the base, and the third arc-shaped rotation block is disposed in the third arc-shaped groove and is configured to implement a rotatable connection between the first swing arm and the first housing support; and
a fourth arc-shaped groove is disposed on the second housing support, a fourth arc-shaped rotation block is disposed at an end that is of the second swing arm and that is away from the base, and the fourth arc-shaped rotation block is disposed in the fourth arc-shaped groove and is configured to implement a rotatable connection between the second swing arm and the second housing support.

11. The hinge mechanism according to any one of claims 5 to 10, wherein a first sliding groove is disposed on the first housing support, in a direction away from the base, a groove bottom of the first sliding groove gradually inclines in a direction close to the first support surface, and the first support arm is slidably disposed in the first sliding groove; and
a second sliding groove is disposed on the second housing support, in a direction away from the base, a groove bottom of the second sliding groove gradually inclines in a direction close to the second support surface, and the second support arm is slidably disposed in the second sliding groove.

12. The hinge mechanism according to any one of claims 5 to 11, wherein a fifth arc-shaped groove is disposed on the first housing support, a fifth arc-shaped rotation block is disposed on the surface that is of the first door plate and that is away from the first support surface, and the fifth arc-shaped rotation block is disposed in the fifth arc-shaped groove and is configured to implement a rotatable connection between the first door plate and the first housing support; and
a sixth arc-shaped groove is disposed on the second housing support, a sixth arc-shaped rotation block is disposed on the surface that is of the second door plate and that is away from the second support surface, and the sixth arc-shaped rotation block is disposed in the sixth arc-shaped groove and is configured to implement a rotatable connection between the second door plate and the second housing support.

13. The hinge mechanism according to any one of claims 1 to 12, wherein a first limiting wall is disposed on the first housing support, and the first limiting wall and the first support arm are spaced in the axial direction of the hinge mechanism; and
the hinge mechanism further comprises a first damping component, and the first damping component is disposed between the first support arm and the first limiting wall, and comprises a first cam, a second cam, and a first elastic member, wherein the first cam is disposed on a side that is of the first support arm and that faces the first limiting wall, the second cam is disposed on a side that is of the first cam and that is away from the first support arm, a cam surface of the second cam presses against a cam surface of the first cam, the first elastic member is disposed on a side that is of the second cam and that is away from the first cam, and the first elastic member is limited between the second cam and the first limiting wall.

14. The hinge mechanism according to claim 13, wherein a first limiting groove disposed in the axial direction of the hinge mechanism is disposed on the first housing support, the first limiting groove has a first opening disposed toward the first support arm, and a bottom wall that is in the first limiting groove and that is disposed opposite to the first opening forms the first limiting wall; and
the first elastic member is disposed in the first limiting groove, at least a part of the second cam is disposed in the first limiting groove, and the cam surface of the second cam presses against the cam surface of the first cam through the first opening.

15. The hinge mechanism according to claim 13 or 14, wherein the first cam and the first support arm are of an integrated structure.

16. An electronic device, comprising a first housing, a second housing, a flexible display, and the hinge mechanism according to any one of claims 1 to 15, wherein
the first housing and the second housing are respectively disposed on two sides of the hinge mechanism, the first housing is connected to the first rotating component, and the second housing is connected to the second rotating component; and
the flexible display continuously covers the first housing, the second housing, and the hinge mechanism, and the flexible display is fastened to the first housing and the second housing.
